# EUROPÄISCHE PATENTANMELDUNG

(11) **EP 1 953 837 A2**
(43) Veröffentlichungstag der Anmeldung: **06.08.2008**
(21) Anmeldenummer: 08150655.2
(22) Anmeldetag: 25.01.2008
(51) Int. Cl.: H01L 33/00

(54) **Halbleiterbauelement mit einer optisch aktiven Schicht, Anordnung mit einer Vielzahl von optisch aktiven Schichten und Verfahren zur Herstellung eines Halbleiterbauelements**

(30) Priorität: 31.01.2007 DE 102007004805; 11.04.2007 DE 102007017113
(71) Anmelder: OSRAM Opto Semiconductors GmbH, 93055 Regensburg (DE)
(72) Erfinder: Herrmann, Siegfried, 94362, Neukirchen (DE)
(74) Vertreter: Epping - Hermann - Fischer

(57) **Zusammenfassung**

Die Erfindung betrifft ein Halbleiterbauelement (11, 19, 30, 40) mit einer optisch aktiven Schicht (2), das durch wenigstens ein Kühlelement (7) und wenigstens ein Koppelelement (10) gekennzeichnet ist. Die Erfindung betrifft des Weiteren eine Anordnung (17) mit einer Vielzahl von optisch aktiven Schichten (2) und ein Verfahren zum Herstellen eines Halbleiterbauelements (11, 19, 30, 40).

## Beschreibung

Halbleiterbauelement mit einer optisch aktiven Schicht, Anordnung mit einer Vielzahl von optisch aktiven Schichten und Verfahren zur Herstellung eines Halbleiterbauelements

Diese Patentanmeldung beansprucht die Priorität der deutschen Patentanmeldungen 10 2007 004 805.1 und 10 2007 017 113.9, deren Offenbarungsgehalt hiermit durch Rückbezug aufgenommen wird.

Die Erfindung betrifft ein Halbleiterbauelement mit einer optisch aktiven Schicht, insbesondere leistungsstarke Leuchtdioden. Des Weiteren betrifft die Erfindung eine Anordnung mit einer Vielzahl von optisch aktiven Schichten und ein Verfahren zum Herstellen eines Halbleiterbauelements.

Halbleiterbauelemente mit optisch aktiven Schichten sind vielfach bekannt. Insbesondere Leuchtdioden (englisch: light emitting diode, kurz LED) werden in einer Vielzahl von Anwendungen und Anordnungen zum Anzeigen von Betriebszuständen und zunehmend auch zur allgemeinen Beleuchtung genutzt. Darüber hinaus sind weitere Halbleiterbauelemente mit aktiven optischen Schichten, wie etwa Dünnschichttransistoren (englisch: thin film transistor, kurz TFT) von aktiven Matrixanzeigen und Laserdioden, bekannt.

Obwohl LEDs und andere Halbleiterbauelemente mit aktiven optischen Schichten im Vergleich zu konventionellen Leuchtmitteln wie etwa Glüh- oder Halogenlampen einen verhältnismäßig hohen Wirkungsgrad aufweisen, wird in den optisch aktiven Schichten neben der Fotoenergie auch Wärme freigesetzt, die zu einer Beeinträchtigung oder Zerstörung des Bauelements führen kann. Um dieses Problem zu beseitigen, muss die Leistung insbesondere leistungsstarker Bauelemente entweder stark gedrosselt werden oder für eine entsprechende Kühlung gesorgt werden.

Aus der US 2004/0075100 A1 ist ein für eine LED geeignetes Gehäuse bekannt. Dieses enthält einen Leiterrahmen und ein separat gefertigtes thermisches Anschlussteil mit einem Chipmontagebereich.

Es ist eine Aufgabe, Halbleiterbauelemente mit alternativem Aufbau zum Abführen von in einer optisch aktiven Schicht erzeugten Wärme zu entwickeln, der für bestimmte Anwendungen besser geeignet ist. Des Weiteren sollen auch eine Anordnung mit einer Vielzahl solcher Halbleiterbauelemente sowie ein Verfahren zu deren Herstellung beschrieben werden.

Es wird ein Halbleiterbauelement mit einer optischen aktiven Schicht beschrieben, das durch ein Kühlelement zum Speichern oder Abführen von durch die optisch aktive Schicht erzeugte Wärme und wenigstens ein Koppelelement gekennzeichnet ist, das die optisch aktive Schicht mit dem Kühlelement mittelbar oder unmittelbar verbindet.

Durch die thermische Ankopplung eines Kühlelementes an die optisch aktive Schicht, kann die von der optisch aktiven Schicht erzeugte Wärme abgeführt oder gespeichert werden.

In einer bevorzugten Ausgestaltung weist das Koppelelement wenigstens einen Hohlraum auf, wobei der Hohlraum teilweise oder vollständig mit einen flüssigen Kühlmedium gefüllt ist.

Die Kombination eines zumindest teilweise hohlen Koppelelements mit einem darin befindlichen flüssigen Kühlmedium erlaubt ein Abführen von in der optischen aktiven Schicht erzeugten Wärme mittels einer Strömung in dem Kühlmedium, beispielsweise durch Konvektion, Wärmetransport oder einer Kombination von Verdampfen und Kondensation, an ein Kühlelement des Halbleiterbauelements. Durch die Verwendung von Konvektion anstelle von Wärmeleitung sowie durch die Verwendung eines flüssigen Kühlmediums können das Koppelelement und das Kühlelement flexibler gestaltet und platziert werden.

Gemäß einer vorteilhaften Ausgestaltung strahlt die optisch aktive Schicht elektromagnetische Strahlung bevorzugt in wenigstens eine Abstrahlrichtung ab, wobei das Kühlelement in einer zur Abstrahlrichtung senkrechten Ebene angeordnet ist. Durch die Anordnung des Kühlelements senkrecht zur Abstrahlrichtung wird eine unbehinderte Strahlung des Halbleiterbauelements ermöglicht.

Gemäß einer weiteren Ausgestaltung sind das Koppelelement und das Kühlmedium zumindest teilweise transparent ausgeführt und in der Abstrahlrichtung über der optisch aktiven Schicht angeordnet. Die Verwendung eines zumindest teilweise transparenten Koppelelementes und Kühlmediums erlaubt es, das Koppelelement in Abstrahlrichtung über der optisch aktiven Schicht anzuordnen, um die Wärme direkt am Ort der Entstehung abzuführen ohne dabei die Ausstrahlung elektromagnetischer Strahlung wesentlich zu behindern.

Gemäß einer weiteren bevorzugten Ausgestaltung ist das Halbleiterbauelement dazu eingerichtet, elektromagnetische Strahlung in zwei einander entgegengesetzte Abstrahlrichtungen abzustrahlen, wobei jeweils ein zumindest teilweise transparentes Koppelelement auf zwei einander gegenüberliegenden Seiten der optisch aktiven Schicht in jeder der zwei Abstrahlrichtungen angeordnet ist. Auf diese Weise lassen sich leistungsstarke, zweiseitig abstrahlende Halbleiterbauelemente gestalten.

Es wird eine Anordnung mit einer Vielzahl von optisch aktiven Schichten angegeben, die dadurch gekennzeichnet ist, dass die Vielzahl optisch aktiven Schichten thermisch an wenigstens einem Koppelelement mit wenigstens einem Hohlraum angekoppelt sind und wenigstens ein Kühlelement zum Speichern oder Abführen von durch die optisch aktiven Schichten erzeugten Wärme an das wenigstens einen Koppelelement angekoppelt ist, wobei der wenigstens eine Hohlraum teilweise oder vollständig mit einem flüssigen Kühlmedium gefüllt ist.

Gemäß einer weiteren vorteilhaften Ausgestaltung ist die Vielzahl von optisch aktiven Schichten rasterförmig angeordnet. Durch die rasterförmige Anordnung von optisch aktiven Schichten werden flächige Anzeigen bzw. Beleuchtungssysteme ermöglicht.

Gemäß einer weiteren vorteilhaften Ausgestaltung umgeben eine Vielzahl von Kühlelementen die Vielzahl von optisch aktiven Schichten zumindest teilweise raster-, streifen- oder ringförmig. Die Verwendung einer Vielzahl von Kühlelementen, die die Vielzahl von optisch aktiven Schichten zumindest teilweise umgeben, ermöglicht eine effektive Kühlung auch von flächigen Anzeige- und Beleuchtungssystemen.

Des Weiteren wird ein Verfahren zum Herstellen eines Halbleiterbauelements beschrieben, das die folgenden Schritte aufweist:
- Bereitstellen wenigstens einer optisch aktiven Schicht,
- Ankoppeln der wenigstens einen optisch aktiven Schicht an ein erstes Koppelelement mit einem Hohlraum,
- Ankoppeln wenigstens eines Kühlelements an das erste Koppelelement und
- teilweises oder vollständiges Füllen des Hohlraums mit einem flüssigen Kühlmedium.

Mittels der oben genannten Schritte können Halbleiterbauelemente und Anordnungen mit Halbleiterbauelementen der oben genannten Art hergestellt werden.

Gemäß einer weiteren vorteilhaften Ausgestaltung des Verfahrens wird die wenigstens eine optisch aktive Schicht auf einem Substrat bereitgestellt, das erste Koppelelement ist zumindest teilweise transparent ausgeführt und nach Aufbringen der wenigstens einen optisch aktiven Schicht auf das erste Koppelelement wird das Substrat von der optisch aktiven Schicht abgelöst, sodass Licht durch die optisch aktive Schicht in Richtung des ersten Koppelelements und in die entgegengesetzte Richtung abstrahlbar ist.

Durch ein derart weiterentwickeltes Verfahren ist es möglich, Halbleiterbauelemente herzustellen, die eine beidseitige Lichtemission ermöglichen.

Weitere Einzelheiten und Ausgestaltungen der Erfindung sind in den Unteransprüchen angegeben.

Die Erfindung wird nachfolgend anhand von Ausführungsbeispielen mit Hilfe folgender Zeichnungen näher erläutert. In den Zeichnungen zeigen:
- Figur 1: ein substratloses Halbleiterbauelement mit einer optisch aktiven Schicht, das zur beidseitigen Lichtemission geeignet ist,
- Figur 2: eine optisch aktive Schicht, die mit einem ringförmigen Kühlelement zum Abführen von durch die optisch aktive Schicht erzeugter Wärme umgeben ist,
- Figur 3A: einen Querschnitt durch ein Halbleiterbauelement mit einer optisch aktiven Schicht, einem Kühlelement und zwei Koppelelementen,
- Figur 3B: eine Draufsicht auf das Halbleiterbauelement gemäß Figur 3A,
- Figur 4: eine Anordnung mit einer Vielzahl von Halbleiterbauelementen,
- Figur 5: ein Halbleiterbauelement mit einer optisch aktiven Schicht, die auf einem Substrat angeordnet ist,
- Figur 6A: einen Querschnitt durch eine weitere Ausgestaltung eines Halbleiterbauelementes,
- Figur 6B: ein Draufsicht auf das Halbleiterbauelement gemäß Figur 6A, und
- Figur 7: eine Draufsicht auf eine weitere Ausgestaltung eines Halbleiterbauelementes.

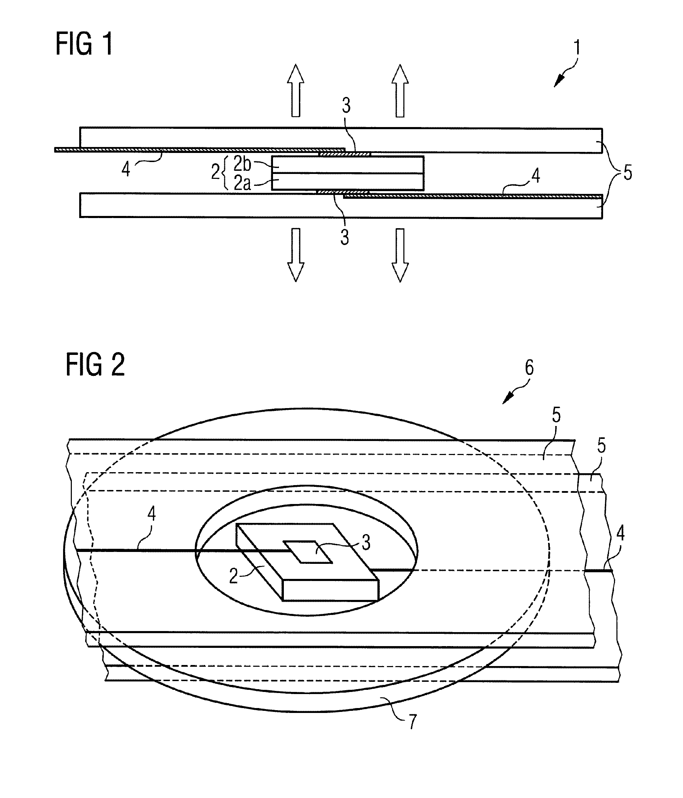

Figur 1 zeigt ein Halbleiterbauelement 1, das zur beidseitigen Emission von Licht geeignet ist. Es umfasst eine optisch aktive Schicht 2, die im dargestellten Ausführungsbeispiel aus einer unteren Teilschicht 2a und einer oberen Teilschicht 2b besteht. Bei der unteren Teilschicht 2a handelt es sich um eine negativ dotierte Indium-Gallium-Nitridschicht, bei der oberen Teilschicht 2b handelt es sich beispielsweise um eine positiv dotierte Indium-Gallium-Nitridschicht. Zusammen bilden die obere Teilschicht 2b und die untere Teilschicht 2a einen pn-Übergang mit einer Bandlücke, die zur Erzeugung blauen Lichts geeignet ist, sodass die optisch aktive Schicht 2 insgesamt als Leuchtdiode wirkt.

Selbstverständlich sind dem Fachmann eine Vielzahl weiterer Halbleitermaterialien und -strukturen bekannt, die zur Emission von elektromagnetischer Strahlung anderer Wellenlängen, auch außerhalb des sichtbaren Spektrums, geeignet sind. Allgemein weist die optisch aktive Schicht mindestens einen aktiven Bereich auf, der zur Erzeugung elektromagnetischer Strahlung geeignet ist.

Nitrid-Verbindungshalbleitermaterialien sind Verbindungshalbleitermaterialien, die Stickstoff enthalten, wie die bereits genannten Materialien aus dem System InₓAl_{y}Ga_{1-x-y}N mit 0 ≤ x ≤ 1, 0 ≤ y ≤ 1 und x+y ≤ 1. Unter die Gruppe von strahlungsemittierenden und/oder strahlungsdetektierenden Halbleiterchips auf Basis von Nitrid-Verbindungshalbleitermaterial fallen vorliegend insbesondere solche Halbleiterchips, bei denen die epitaktisch hergestellte Halbleiterschicht, die in der Regel eine Schichtfolge aus unterschiedlichen Einzelschichten aufweist, mindestens eine Einzelschicht enthält, die ein Material aus dem Nitrid-Verbindungshalbleitermaterial-System aufweist. Die Halbleiterschicht kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden von daher an dieser Stelle nicht näher erläutert. Beispiele für solche MQW-Strukturen sind in den Druckschriften WO01/39282, US 6,172,382, US 5,831,277 und US 5,684,309 beschrieben, deren Offenbarungsgehalt insofern hiermit durch Rückbezug aufgenommen wird.

Zum Zuführen eines Betriebsstroms sind die untere Teilschicht 2a und die obere Teilschicht 2b jeweils mit einem Kontakt 3 und einer Zuleitung 4 versehen. Um die optisch aktive Schicht 2 vor Beschädigungen zu schützen und gegebenenfalls mit einem Träger zu verbinden, ist sie zwischen zwei transparenten Folien 5 eingeschlossen, die auf der Ober- bzw. Unterseite der optisch aktiven Schicht 2 angeordnet sind. Gegenüber konventionellen Leuchtdioden, die auf einem lichtundurchlässigen Substrat aufgebracht sind, ergibt sich somit der Vorteil, dass Licht von der optisch aktiven Schicht 2 sowohl nach oben als auch nach unten emittiert werden kann.

Bei dem Halbleiterbauelement 1 gemäß Figur 1 wird die in der optisch aktiven Schicht 2 erzeugte Wärme über die transparenten Folien 5 abgeführt.

Das Abführen einer von einer optisch aktiven Schicht 2 erzeugten Wärme ist nicht nur bei beidseitig emittierenden Halbleiterbauelementen, wie sie in der Figur 1 dargestellt sind, vorteilhaft. Vielmehr sorgt es grundsätzlich auch bei jedem anderen Halbleiterbauelement für eine verbesserte Leistungsfähigkeit. Insbesondere bei Halbleiterbauelementen, die auf einem räumlich eng begrenzten Bereich verhältnismäßig viel Wärme erzeugen, ist dies von Bedeutung. Dies trifft insbesondere auch auf so genannte Chip Arrays zu, also Anordnungen mit einer Vielzahl von Halbleiterbauelementen wie sie später beschreiben werden.

Figur 2 zeigt einen verbesserten Aufbau eines Halbleiterbauelements 6 zum Abführen von in einer optisch aktiven Schicht 2 erzeugten Wärme. Hierzu ist die optisch aktive Schicht 2, die z. B. in äquivalenter Weise zur optisch aktiven Schicht 2 der Figur 1 aufgebaut ist, von einem ringförmigen Kühlelement 7 umgeben. Das Kühlelement 7 besteht im Ausführungsbeispiel im Wesentlichen aus einem Metall mit hoher Wärmekapazität und guter Wärmeleitfähigkeit. Anstelle eines Metalls kann jedoch auch ein Keramikmaterial Verwendung finden, oder jegliches anderes Material, das über geeignete thermische Eigenschaften verfügt.

Zur Übertragung der Wärme von der optisch aktiven Schicht 2 auf das Kühlelement 7 werden zwei transparente Folien 5, je eine über und unter der optisch aktiven Schicht 2 bzw. dem Kühlelement 7 verwendet.

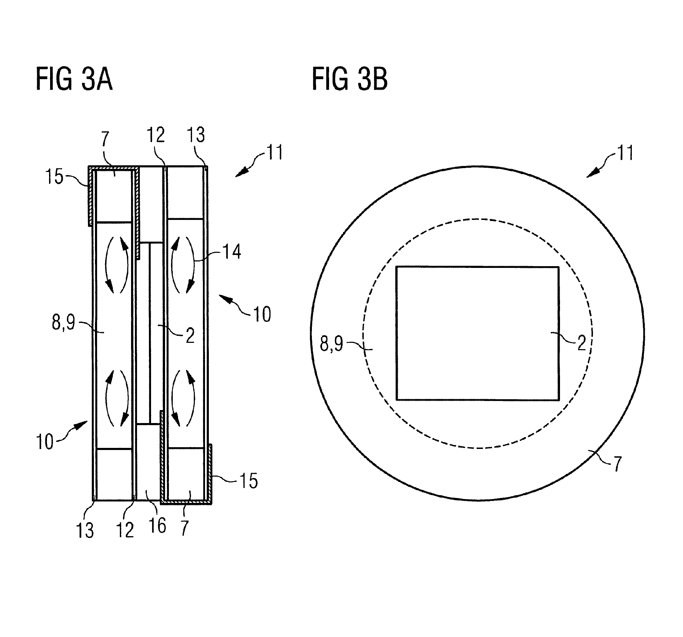

Um die Wärmeleitung von der optisch aktiven Schicht zum Kühlelement 7 zu verbessern, wird in einem weiter verbesserten Ausführungsbeispiel, das in den Figuren 3A und 3B dargestellt ist, ein flüssiges Kühlmedium 8 verwendet, das in einem Hohlraum 9 eines Koppelelements 10 eingeschlossen ist.

Im in der Figur 3A dargestellten Querschnitt des Ausführungsbeispiels umfasst ein Halbleiterbauelement 11 eine optisch aktive Schicht 2, die zwischen zwei Koppelelementen 10 eingeschlossen ist. Jedes der Koppelelement 10 umfasst dabei eine erste Folie 12, die der optisch aktiven Schicht 2 zugewandt ist, sowie eine zweite Folie 13, die auf der der optischen Schicht 2 abgewandten Seite des Koppelelements 10 liegt. Zwischen der ersten Folie 12 und der zweiten Folie 13 ist jeweils ein Kühlelement 7 eingeschlossen, das zugleich die äußere Begrenzung des Hohlraums 9 bildet.

Wie durch die Pfeile in den Koppelelementen 10 der Figur 3A dargestellt, erhitzt sich das flüssige Kühlmedium 8 im Bereich der optisch aktiven Schicht 2 und kühlt im Bereich des Kühlelements 7 wieder ab. Hierdurch entsteht eine Konvektionsströmung 14, die für einen effektiven Wärmetransport von der optisch aktiven Schicht 2 zu dem Kühlelement 7 sorgt.

Je nach Anwendungsgebiet eignen sich als Kühlmedium 8 beispielsweise Ethanol und Ethanol-Wasser Mischungen. Alkohol ist ungiftig, niedrigviskos, transparent, hat eine verhältnismäßig hohe Wärmekapazität und einen niedrigen Gefrierpunkt, so dass es sich beispielsweise für Anwendungen im Außen- und Automobilbereich eignet. Glycol-, Ethylenglycol- und Glycerin-Zusätze können ebenfalls Verwendung finden. Wasser allein besitzt zwar eine noch höherer Wärmekapazität, ist aufgrund seines verhältnismäßig hohen Schmelzpunktes und seiner Anomalie aber eher für Anwendungen im Innenbereich geeignet.

Im Ausführungsbeispiel sind die Zuleitungen 4 zu äußeren Kontaktflächen 15 herausgeführt, die zum elektrischen Anschluss des Halbleiterbauelements 11 dienen. Die optisch aktive Schicht 2 ist von einem Festkörper 16 eingeschlossen, der zur Positionierung und zum Schutz der optisch aktiven Schicht 2 innerhalb des Halbleiterbauelements 11 dient. Mechanische Belastungen, die auf das Koppelelement 10 und das Kühlelement 7 einwirken, werden somit nicht auf die optisch aktive Schicht 2 sondern auf den Festkörper 16 übertragen.

In der Figur 3B ist das Halbleiterbauelement 11 in der Draufsicht dargestellt. Darin ist zu erkennen, dass das Kühlelement 7 als Ring um die optisch aktive Schicht 2 ausgeführt ist. Selbstverständlich kann auch jede andere Geometrie für das Kühlelement 7 gewählt werden, beispielsweise ein quadratischer Einschluss.

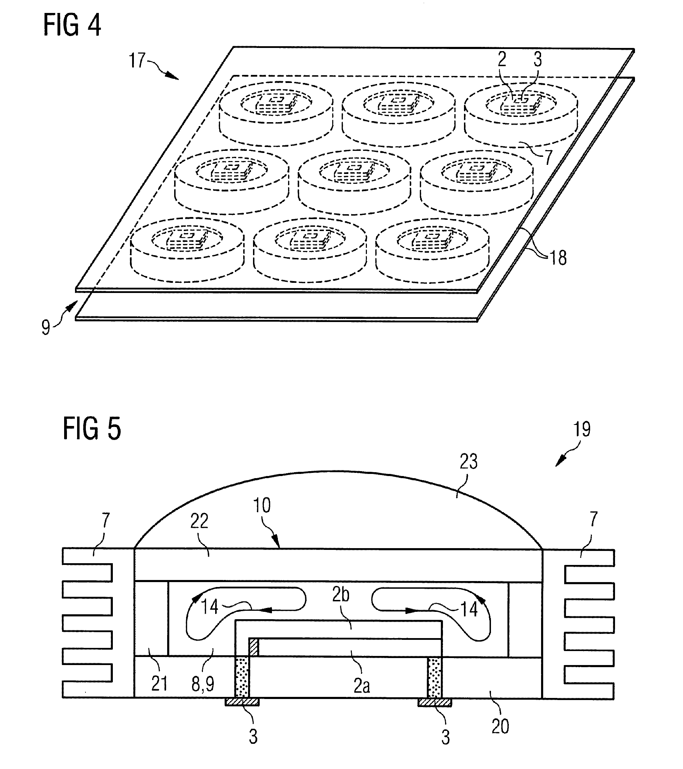

Bei einzelnen Halbleiterbauelementen 11, wie sie in der Figur 3A und 3B dargestellt sind, dient das ringförmige Kühlelement 7 zur Herstellung einer besonders vorteilhaften Bauteil-Symmetrie. Bei anderen Halbleiterbauelementen, insbesondere bei rasterförmig angeordneten, optisch aktiven Schichten 2, kann es jedoch sinnvoll sein, auch das oder die Kühlelemente 7 in Form eines Rasters oder in Form von Kühlstreifen oder -rippen auszuführen.In der Figur 4 ist eine Anordnung 17 mit einer Vielzahl von optisch aktiven Schichten 2 dargestellt. Die einzelnen optisch aktiven Schichten 2 entsprechen dabei beispielsweise der in der Figur 1 dargestellten optisch aktiven Schicht 2. In der Anordnung 17 sind neun optisch aktive Schichten 2 mit Kontakten 3 und Zuleitungen 4 sowie einem Kühlelement 7 zwischen zwei gemeinsamen Folien 18, die als Koppelelement 10 wirken, eingeschlossen. Die Anordnung 17 emittiert somit sowohl flächig als auch auf beiden Seiten der Folien 18 Licht und ermöglicht somit eine besonders vorteilhafte Ausleuchtung des umgebenden Raums.

Zur Verbesserung der Kühlung wird der Hohlraum 9 zwischen den Folien 18 mit einem Kühlmedium 8 aufgefüllt. Sofern das Kühlmedium 8 elektrisch leitend ist und direkt mit den optisch aktiven Schichten 2, den Kontakten 3 oder den Zuleitungen 4 in Kontakt tritt, müssen diese durch geeignete Maßnahmen elektrisch isoliert werden. Beispielsweise kann auf der optisch aktiven Schicht 2 eine transparente Oxidschicht, wie etwa eine Indium-Zinn-Oxid-Schicht (ITO) aufgebracht werden.

In einer alternativen Ausgestaltung können im Bereich der einzelnen optisch aktiven Schichten 2 innerhalb der Folien 18 auch ein oder mehrere Hohlräume 9 vorgesehen sein, die eine Kühlung der optisch aktiven Schichten 2 ermöglichen. Gemäß einer weiteren Ausgestaltung sind ein oder mehrere Hohlräume 9 über den Folien 18 angeordnet, die zur gemeinsamen Kühlung aller optisch aktiven Schichten 2 dienen.

Selbstverständlich kann das oben beschriebene Kühlkonzept auch in anderen Halbleiterbauelementen mit optisch aktiven Schichten eingesetzt werden. Figur 5 zeigt ein weiteres Beispiel eines Halbleiterbauelements 19, das nur zur einseitigen Abstrahlung geeignet ist. In dem Ausführungsbeispiel handelt es sich bei dem Halbleiterbauelement 19 um eine besonders leistungsfähige LED aus dem Automobilbereich.

Auf einem Substrat 20 wird eine optisch aktive Schicht 2, bestehend aus einer unteren Schicht 2a und einer oberen Schicht 2b, gebildet, die zusammen genommen eine Diodenstruktur ergeben. Die untere Teilschicht 2a und die obere Teilschicht 2b können über Kontakte 3 mit einer Betriebsspannung versorgt werden.

Bei der optisch aktiven Schicht 2 handelt es sich im Ausführungsbeispiel um eine besonders leistungsfähige Diodenstruktur, die nicht allein mittels Wärmeleitung über das Substrat 20 gekühlt werden kann. Deshalb sind auf dem Substrat 20 zusätzlich Abstandshalter 21 angeordnet, die zusammen mit einem Abdeckglas 22 einen Hohlraum 9 im Bereich der optisch aktiven Schicht 2 bilden. Der Hohlraum 9 ist mit einem transparenten, flüssigen Kühlmedium 8 befüllt, sodass sich im Betrieb des Halbleiterbauelements 19 eine Konvektionsströmung 14 in dem flüssigen Kühlmedium 8 ausbildet. Hierdurch wird die in der optisch aktiven Schicht 2 erzeugte Wärme zunächst an die Abstandshalter 21 und das Deckglas 22 abgeführt. Zusammen bilden das Substrat 20, die Abstandshalter 21 und das Abdeckglas 22 mit dem darin befindlichen Hohlraum 9 und der Kühlflüssigkeit 8 ein Koppelelement 10.

Allgemein ist es möglich, die optisch aktive Schicht 2 vollständig mit dem Koppelelement 10 oder dem flüssigen Kühlmedium 8 zu umgeben, um eine allseitige Wärmeabfuhr zu gewährleisten.

An der Außenseite der Abstandshalter 21 sind zur Verbesserung der Kühlleistung weitere Kühlelemente 7 angeordnet, die die an die Abstandshalter 21 abgegebene Wärme weiter abführen. Beispielsweise kann es sich bei den Kühlelementen 7 um eine Gehäusewand oder Kühlrippen des Bauelements 19 handeln.

Zur Verbesserung der optischen Leistung, insbesondere zur Bündelung des von der optisch aktiven Schicht 2 ausgesandten Lichts, ist auf dem Deckglas 22 ein optisches Element 23 angeordnet. Beispielsweise kann es sich um eine Linsen- oder Prismenoptik handeln, die ein anwendungsbedingtes Strahlungsprofil, wie Beispielsweise den Leuchtkegel eines Autoscheinwerfers, erzeugt.

Wie aus der Figur 5 ersichtlich wird, kann das Kühlelement 7 im Vergleich zu herkömmlichen Anordnungen, bei denen es in der Regel auf der Rückseite des Substrats 20 angeordnet ist, wesentlich flexibler platziert werden. Als weiterer Vorteil werden das Substrat 20 und eventuell weitere vorhandene Komponenten oder Schichten des Halbleiterbauelementes 19 thermisch weniger belastet, so dass deren Lebensdauer steigt.

Um die Kühlleistung weiter zu erhöhen, kann das flüssige Kühlmedium 8 auch durch Einwirkung externer Kräfte durch den Hohlraum 9 getrieben werden. Insbesondere bei verhältnismäßig großen Anordnungen ist eine erzwungene Kühlung durch Verwendung einer Pumpe zur Erhöhung des Flüssigkeitsdurchsatzes möglich.

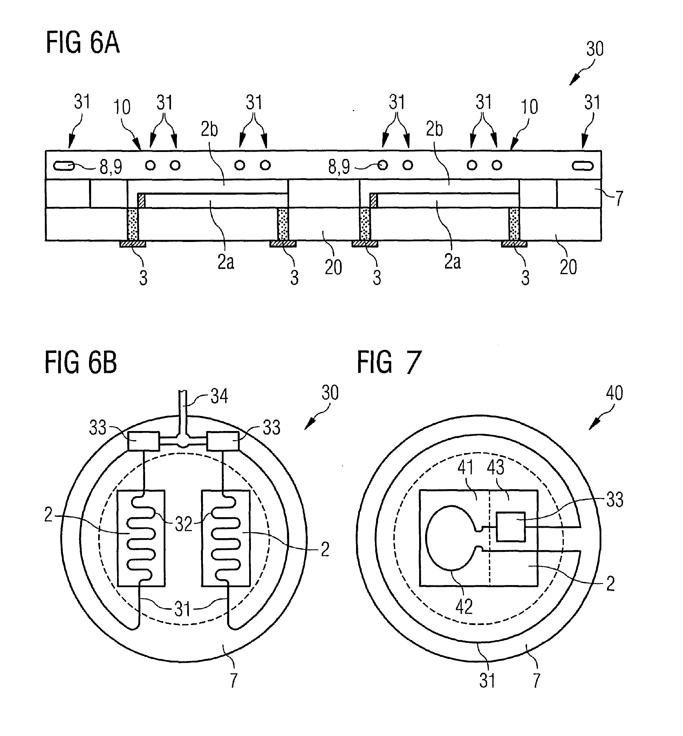

Figur 6A und 6B zeigen eine weitere Ausgestaltung eines Halbleiterbauelementes 30.

Das Halbleiterbauelement 30 umfasst zwei optisch aktive Schichten 2, die jeweils eine untere und eine obere Teilschicht 2a beziehungsweise 2b umfassen. Die optisch aktiven Schichten 2 sind auf einem Substrat 20 angeordnet und werden über Kontakte 3 mit einer Betriebsspannung versorgt.

Des Weiteren sind die optisch aktiven Schichten 2 über ein gemeinsames Koppelelement 10, im Ausführungsbeispiel eine strukturierte, transparente Schicht mit darin enthaltenen Mikrokavitäten 31, mit einem ringförmigen Kühlelement 7 verbunden. Anders als im vorangegangenen Ausführungsbeispiel durchströmt das flüssige Kühlmedium 8 nur die Mikrokavitäten 31, die Hohlräume 9 in dem Koppelelement 10 bilden. Ein direkter Kontakt zwischen dem flüssigem Kühlmedium 8 und der optisch aktiven Schicht 2 findet nicht statt.

Figur 6B zeigt eine Draufsicht auf das Halbleiterbauelement 30 mit zwei optisch aktiven Schichten 2. In der Draufsicht ist zu erkennen, dass die Mikrokavitäten 31 Kühlschlangen 32 im Bereich der optisch aktiven Schichten 2 bilden. Mittels Mikropumpen 33 wird das flüssige Kühlmedium 8 durch die Kühlschlangen 32 und dann durch die Fortsetzung der Mikrokavitäten 31 im Bereich des Kühlelementes 7 gepumpt. Ebenfalls im Bereich des Kühlelementes 7 ist ein Ausgleichsgefäß 34 angeordnet, das zur Druckentlastung des Kühlkreislaufs bei starker Erwärmung beziehungsweise Abkühlung dient.

Figur 7 zeigt eine weitere Ausgestaltung eines Halbleiterbauelementes 40.

Bei dem Halbleiterbauelement 40 sind Mikrokavitäten 31 direkt in das Substrat 20 oder die optisch aktive Schicht 2 des Halbleiterbauelementes 40 integriert. Dies ist insbesondere dann sinnvoll, wenn nur ein Teil der optisch aktiven Schicht 2 tatsächlich Licht aussendet, während andere Teile der optisch aktiven Schicht 2 weitere Halbleiterkomponenten umfassen.

Im in der Figur 7 gezeigten Ausführungsbeispiel ist ein erster Bereich 41 der optisch aktiven Schicht 2 zum Aussenden elektromagnetischer Strahlung eingerichtet, zum Beispiel durch geeignete Dotierung, Ätzung oder andere Halbleiterbearbeitungstechniken. In dem ersten Bereich 41 ist zugleich eine Kühlwindung 42 in Form einer Mikrokavität 31 angeordnet, die ein Abführen der Wärme direkt am Ort der Entstehung ermöglicht.

In einem zweiten Bereich 43 der optisch aktiven Schicht 2 ist eine Mikropumpe 33 angeordnet, die ein flüssiges Kühlmedium 8 durch die Kühlwindung 42 fördert. Nachdem das flüssige Kühlmedium 8 die Kühlwindung 42 durchströmt hat, fließt es durch die Mikrokavität 31 im Bereich eines Kühlelementes 7, das die optisch aktive Schicht 2 ringförmig umgibt, zurück und gibt die von der optisch aktiven Schicht 2 aufgenommene Wärme ab. Die Mikropumpe 33 beziehungsweise die zu ihrem Betrieb nötige Ansteuerelektronik kann direkt in die optisch aktive Schicht 2 oder ein darunter befindliches Substrat 20 integriert werden.

Überdeckt der Hohlraum 9 beziehungsweise das flüssige Kühlmedium 8 nur Teile der optisch aktiven Schicht 2 oder befindet er sich am Rand des Strahlenganges, wie beispielsweise in der Figur 7 dargestellt, kann auch ein nicht transparentes flüssiges Kühlmedium 8 eingesetzt werden. Auch die Wandungen des Hohlraums 9 müssen dann nicht aus einem transparenten Material bestehen.

Es ist auch möglich, eine oder mehrere optisch aktive Schichten mit einem ringförmigen Hohlraum 9 zu umgeben, der zur Kühlung der optisch aktiven Schicht mit einem flüssigen Kühlmedium 8 gefüllt. Beispielsweise ließe sich der verbleibenden Hohlraum zwischen der optisch aktiven Schicht 2 und dem Kühlelement 7 gemäß Figur 7 ebenfalls zum Ausbilden einer Kühlströmung nutzen.

Alternativ kann auch eine so genannte Heatpipe, also ein Wärmerohr, als Koppelelement 10 zum besseren und schnelleren Abführen von Wärme verwendet werden. Wärmeröhren eignen sich insbesondere in Anordnungen, in denen der Abstand zwischen dem Halbleiterbauelement und dem Kühlelement 7 verhältnismäßig groß ist. Ein Wärmerohr enthält einen teilweise mit einem flüssigen Kühlmedium 8 gefüllten Hohlraum 9. In dem Wärmerohr herrscht ein niedriger Druck vor, so dass das Kühlmedium 8 im Bereich einer Wärmequelle schon bei geringem Temperaturanstieg verdampft. Das gasförmige Kühlmedium 8 gelangt durch das Wärmerohr in einen Bereich des Kühlelements 7, in dem es durch Kondensation die aufgenommenen Wärme wieder abgibt. Anschließend gelangt das flüssige Kühlmedium 8 wieder zurück in den Bereich der Wärmequelle, beispielsweise durch Verwendung eines Dochts, einer Kapillare oder einfach durch Gravitationskraft.

In einer weiteren vorteilhaften Ausgestaltung wird eine Kältemaschine zur aktiven Kühlung verwendet, zum Beispiel in Form einer Kompressionskältemaschine. Dazu wird ein zunächst gasförmiges Kühlmedium 8, beispielsweise eine Kohlenwasserstoffverbindung, mittels eines Kompressors verdichtet und so im Bereich des Kühlelementes 7 in einem Kondensator verflüssigt, wobei Wärme abgegeben wird. Über eine Drossel, beispielsweise in Form eines Kapillarrohrs, wird das dann flüssige Kühlmedium 8 in den Hohlraum 9 geleitet, wobei der Druck in dem Kondensator höher als der Druck in dem Hohlraum 9 ist. Somit wirkt der Hohlraum 9 als Verdampfer und kühlt die optisch aktive Schicht 2 mittels Wärmeaufnahme. Das dann wieder gasförmige Kühlmedium 8 wird nachfolgend erneut verdichtet, so dass ein geschlossener Kühlkreislauf entsteht.

Die Erfindung ist nicht durch die Beschreibung der Erfindung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Halbleiterbauelement (11, 19, 30, 40) mit einer optisch aktiven Schicht (2), **gekennzeichnet durch**
- wenigstens ein Kühlelement (7) zum Speichern oder Abführen von **durch** die optisch aktive Schicht (2) erzeugter Wärme und
- wenigstens ein Koppelelement (10), das die optisch aktive Schicht (2) mit dem Kühlelement (7) verbindet und wenigstens einen Hohlraum (9) aufweist, wobei der Hohlraum (9) teilweise oder vollständig mit einem flüssigen Kühlmedium (8) befüllt ist.

2. Halbleiterbauelement (11, 19, 30, 40) nach Anspruch 1,
**dadurch gekennzeichnet, dass**
die optisch aktive Schicht (2) elektromagnetische Strahlung bevorzugt in wenigstens eine Abstrahlrichtung abstrahlt, wobei das wenigstens eine Kühlelement (7) in einer zur Abstrahlrichtung senkrechten Ebene angeordnet ist.

3. Halbleiterbauelement (11, 19, 30, 40) nach Anspruch 2,
**dadurch gekennzeichnet, dass**
das wenigstens eine Kühlelement (7) die optisch aktive Schicht (2) in der senkrechten Ebene zumindest teilweise einschließt.

4. Halbleiterbauelement (11, 19, 30) nach Anspruch 2 oder 3,
**dadurch gekennzeichnet, dass**
das wenigstens eine Koppelelement (10) zumindest teilweise transparent ausgeführt und in der Abstrahlrichtung über der optisch aktiven Schicht (2) angeordnet ist.

5. Halbleiterbauelement (11) nach Anspruch 4,
**dadurch gekennzeichnet, dass**
das Halbleiterbauelement (11) dazu eingerichtet ist, elektromagnetische Strahlung in zwei einander entgegengesetzte Abstrahlrichtungen abzustrahlen.

6. Halbleiterbauelement (11) nach Anspruch 5,
**dadurch gekennzeichnet, dass**
jeweils ein transparentes Koppelelement (10) auf zwei einander gegenüberliegenden Seiten der optisch aktiven Schicht (2) in jeder der zwei Abstrahlrichtungen angeordnet ist.

7. Halbleiterbauelement (19, 30, 40) nach einem der Ansprüche 1 bis 4, **dadurch gekennzeichnet, dass**
die optisch aktive Schicht (2) auf einem Substrat (20) angeordnet ist und elektromagnetische Strahlung bevorzugt senkrecht zu einer Oberfläche des Substrats (20) abstrahlt.

8. Halbleiterbauelement (11, 19) nach einem der Ansprüche 1 bis 7, **dadurch gekennzeichnet, dass**
das Koppelelement (10) wenigstens eine transparente Folie (12, 18) umfasst, die auf der optisch aktiven Schicht (2) angeordnet ist.

9. Halbleiterbauelement (11, 19, 30, 40) nach einem der Ansprüche 1 bis 8, **dadurch gekennzeichnet, dass** das Kühlelement (7) ringförmig ausgebildet ist.

10. Halbleiterbauelement (11, 19, 30, 40) nach einem der Ansprüche 1 bis 9, **dadurch gekennzeichnet, dass**
das Kühlelement (7) ein metallisches und/oder keramisches Material enthält.

11. Halbleiterbauelement (11, 19, 30, 40) nach einem der Ansprüche 1 bis 10, **dadurch gekennzeichnet, dass**
das Halbleiterbauelement (11, 19, 30, 40) einen aktiven Kühlkreislauf umfasst und dazu eingerichtet ist, das flüssige Kühlmedium (8) in dem wenigstens einen Hohlraum (9) zu verdunsten.

12. Halbleiterbauelement (30, 40) nach einem der Ansprüche 1 bis 11, **dadurch gekennzeichnet, dass**
das Koppelelement (10) wenigstens eine Mikrokavität (31) umfasst, die dazu geeignet ist, von dem flüssigen Kühlmedium (8) durchströmt zu werden.

13. Halbleiterbauelement (40) nach Anspruch 12,
**dadurch gekennzeichnet, dass**
die optisch aktive Schicht (2) und das Koppelelement (10) einstückig gefertigt sind, wobei die wenigstens eine Mikrokavität (31) in der optisch aktiven Schicht (2) angeordnet ist.

14. Halbleiterbauelement (40) nach einem der Ansprüche 1 bis 13, **dadurch gekennzeichnet, dass**
der wenigstens eine Hohlraum (9) die optisch aktive Schicht (2) in einer zu einer Abstrahlrichtung senkrechten Ebene im Wesentlichen ringförmig umschließt.

15. Halbleiterbauelement (11, 19, 30, 40) nach einem der Ansprüche 1 bis 14, **dadurch gekennzeichnet, dass**
das Koppelelement (10) ein teilweise mit dem flüssigen Kühlmedium (8) gefülltes Wärmeleitrohr umfasst.

16. Halbleiterbauelement (30, 40) nach einem der Ansprüche 1 bis 15, **dadurch gekennzeichnet, dass**
das flüssige Kühlmedium (8) durch den wenigstens einen Hohlraum (9) gepumpt wird.

17. Anordnung (17) mit einer Vielzahl von optisch aktiven Schichten (2), **dadurch gekennzeichnet, dass**
- die Vielzahl von optisch aktiven Schichten (2) thermisch an wenigstens ein Koppelelement (10) mit wenigstens einem Hohlraum (9) angekoppelt sind,
- wenigstens ein Kühlelement (7) zum Speichern oder Abführen von durch die optisch aktiven Schichten (2) erzeugte Wärme enthalten und an das wenigstens einen Koppelelement (10) thermisch angekoppelt ist, wobei
- der wenigstens eine Hohlraum (9) teilweise oder vollständig mit einem flüssigen Kühlmedium (8) gefüllt ist.

18. Anordnung (17) nach Anspruch 17,
**dadurch gekennzeichnet, dass**
die Vielzahl von optisch aktiven Schichten (2) rasterförmig angeordnet ist.

19. Anordnung (17) nach Anspruch 17 oder 18,
**dadurch gekennzeichnet, dass**
eine Vielzahl von Kühlelementen (7) die Vielzahl von optisch aktiven Schichten (2) zumindest teilweise raster-, streifen- oder ringförmig umgeben.

20. Anordnung (17) nach einem der Ansprüche 17 bis 19,
**dadurch gekennzeichnet, dass**
das wenigstens eine Koppelelement (10) zumindest teilweise transparent ausgeführt ist.

21. Verfahren zum Herstellen eines Halbleiterbauelements (11, 19, 30, 40) mit den Schritten:
- Bereitstellen wenigstens einer optisch aktiven Schicht (2),
- thermisches Ankoppeln der wenigstens einen optisch aktiven Schicht (2) an ein erstes Koppelelement (10) mit wenigstens einem Hohlraum (9),
- thermisches Ankoppeln wenigstens eines Kühlelements (7) an das erste Koppelelement (10) und
- teilweises oder vollständiges Füllen des Hohlraums (9) mit einem flüssigen Kühlmedium (8).

22. Verfahren nach Anspruch 21, **dadurch gekennzeichnet, dass** das erste Koppelelement (10) eine erste und eine zweite Schicht aufweist, die wenigstens eine optisch aktive Schicht (2) und das wenigstens eine Kühlelement (7) auf die erste Schicht aufgebracht werden und die zweite Schicht so auf der ersten Schicht angeordnet wird, dass zwischen der ersten und der zweiten Schicht der Hohlraum (9) für das flüssige Kühlmedium (8) entsteht.

23. Verfahren nach Anspruch 21 oder 22,
**dadurch gekennzeichnet, dass**
- die wenigstens eine optisch aktive Schicht (2) auf einem Substrat (20) bereitgestellt wird,
- das erste Koppelelement (10) zumindest teilweise transparent ausgeführt ist und
- nach Aufbringen der wenigstens einen optisch aktiven Schicht (2) auf dem ersten Koppelelement (10) das Substrat (20) von der optisch aktiven Schicht (2) abgelöst wird, sodass Licht durch die optisch aktive Schicht (2) in Richtung des ersten Koppelelements (10) und in die entgegengesetzte Richtung abstrahlbar ist.

24. Verfahren nach Anspruch 23 mit dem zusätzlichen Schritt
- Aufbringen eines zweiten, zumindest teilweise transparent ausgeführten Koppelelements (10) auf der dem ersten Koppelelement (10) gegenüberliegenden Seite der wenigstens einen optisch aktiven Schicht (2).
